# EUROPÄISCHE PATENTANMELDUNG

(11) **EP 1 262 765 A1**
(43) Veröffentlichungstag der Anmeldung: **04.12.2002**
(21) Anmeldenummer: 01112789.1
(22) Anmeldetag: 28.05.2001
(51) Int. Cl.: G01N 25/72

(54) **Verfahren und Vorrichtung zur Detektion von defekten Leiterplattenrohlingen**

(71) Anmelder: Solectron GmbH, 71083 Herrenberg (DE)
(72) Erfinder: Klugkist, Peter Dr., 70599 Stuttgart (DE); Nemeth, Bodo Dr., 74847 Obrigheim (DE)
(74) Vertreter: Steil, Christian, Dipl.-Ing.

(57) **Zusammenfassung**

Die Erfindung betrifft ein Verfahren sowie eine Vorrichtung zur Detektion von oberflächennahen Defekten (18) in Leiterplattenrohlingen (10), die in einer Zwischenschicht (14) unterhalb einer den Leiterplattenrohling (10) zu einer Bestückungsseite (28) hin abschließenden Deckschicht auftreten. Es wird vorgeschlagen, einen vorzugsweise senkrecht zur Zwischenschicht (14) ausgerichteten Temperaturgradienten in wenigstens einem oberflächennahen Bereich der Zwischenschicht (14) zu erzeugen und dann die Temperaturverteilung in der Deckschicht (16) z.B. mit Hilfe einer Infrarotkamera zu erfassen (Fig. 2).

## Beschreibung

Die Erfindung betrifft ein Verfahren und eine Vorrichtung zur Detektion von oberflächennahen Defekten in Leiterplattenrohlingen, die in einer Zwischenschicht unterhalb einer den Leiterplattenrohling zu einer Bestückungsseite hin abschließenden Deckschicht auftreten.

Leiterplattenrohlinge weisen eine oder zwei Bestückungsseiten auf, die mit strukturierten elektrischen Leiterbahnen versehen sind und bei der Herstellung elektrischer Leiterplatten mit passiven oder aktiven elektrischen Bauteilen bestückt werden. Verbreitet ist dabei insbesondere das sog. SMT-Verfahren (SMT = surface mounted technology), bei dem für dieses Verfahren besonders ausgelegte sog. SMD-Bauelemente (SMD = surface mounted device) unmittelbar auf die Oberfläche der Leiterplatten aufgelötet werden. Auf die ansonsten erforderlichen Löcher in den Leiterplattenrohlingen zur Aufnahme von Anschlußdrähten der Bauelemente kann bei dieser Technologie verzichtet werden.

Leiterplattenrohlinge bestehen aus einem Träger, wobei überwiegend Glas und Kunststoffe wie Polyimide oder Epoxydharze als Trägermaterialien eingesetzt werden. Die Leiterbahnen bestehen meist aus einer Grundschicht aus Kupfer, die häufig von einer dünnen Zwischenschicht und einer darüber angeordneten, den Leiterplattenrohling zu der Bestückungsseite hin abschließenden Deckschicht bedeckt ist. Die Zwischenschicht hat die Aufgabe, die darunter liegende Grundschicht vor Korrosion zu schützen, während die Deckschicht das Auflöten elektrischer Bauelemente erleichtert. Bei sogenannten ENIG-Leiterplatten (ENIG = electroless nickel immersion gold) besteht die Zwischenschicht aus Nickel und die Deckschicht aus Gold.

Es hat sich gezeigt, daß die Zwischenschicht bei derart aufgebauten Leiterplattenrohlingen gelegentlich lokale Defekte aufweist. Bei diesen Defekten handelt es sich in der Regel um Spuren von Korrosionsprodukten, bei Zwischenschichten aus Nickel z.B. Nickelphosphid oder Nickeloxid, die sich an der zur Deckschicht weisenden Oberfläche der Zwischenschicht anreichern.

Die Umstände, die zu diesen Korrosionserscheinungen führen, sind bislang nicht geklärt, so daß keine Maßnahmen bekannt sind, mit denen das Auftreten dieser Defekte verhindert werden könnte. Werden elektrische Bauelemente im Bereich derartiger Defekte auf den Leiterbahnen aufgelötet, so kommt häufig keine zuverlässige Lötung zustande, da das verwendete Lot sich nicht oder nicht vollständig mit den Korrosionsprodukten verbindet. Diese defekten Bereiche werden auch als "black pads" bezeichnet. Als Folge davon kann es zu elektrischen Fehlfunktionen oder sogar zum Herabfallen der elektrischen Bauelemente von der Leiterplatte kommen.

Die Schwierigkeit besteht nun darin, daß diese Defekte aufgrund der darüber liegenden Deckschicht von außen nicht erkennbar sind. Nur nach einer Zerstörung der Deckschicht können diese Defekte an der Oberfläche der Zwischenschicht von außen entdeckt werden. Allenfalls bei einer funktionellen Leiterplattenprüfung im Anschluß an deren Herstellung sind diese Defekte feststellbar; häufig jedoch treten Fehlfunktionen erst später auf, so daß fehlerhafte Leiterplatten unerkannt die Produktion verlassen.

Es ist daher Aufgabe der Erfindung, ein Verfahren und eine Vorrichtung zur Detektion von oberflächennahen Defekten in Leiterplattenrohlingen der eingangs genannten Art derart zu verbessern, daß die Detektion zerstörungsfrei erfolgen kann.

Hinsichtlich des Verfahrens wird diese Aufgabe durch folgende Schritte gelöst:
a) Erzeugen eines vorzugsweise senkrecht zur Zwischenschicht ausgerichteten Temperaturgradienten in wenigstens einem oberflächennahen Bereich der Zwischenschicht;
b) Erfassen der Temperaturverteilung in der Deckschicht.

Hinsichtlich der Vorrichtung wird die gestellte Aufgabe gelöst durch:
a) ein Heiz- oder Kühlmittel zum Erzeugen eines vorzugsweise senkrecht zur Zwischenschicht ausgerichteten Temperaturgradienten in wenigstens einem oberflächennahen Bereich der Zwischenschicht;
b) einen Temperaturmesser zum Erfassen der Temperaturverteilung in der Deckschicht.

Die Erfindung beruht auf der Erkenntnis, daß im Bereich der Defekte die Wärmeleitfähigkeit der Zwischenschicht lokal verringert ist. Diese lokale Herabsetzung der Wärmeleitfähigkeit wird erfindungsgemäß dazu ausgenutzt, die Defekte durch die Deckschicht hindurch zu detektieren. Hierzu kann die Zwischenschicht über die Grundschicht, vorzugsweise aber über die Deckschicht, entweder erwärmt oder abgekühlt werden, um auf diese Weise einen Temperaturgradienten innerhalb des oberflächennahen Bereichs der Zwischenschicht, in dem die Defekte üblicherweise auftreten, zu erhalten. Da dann ein Wärmetransport in der Zwischenschicht stattfindet, führen die Defekte zu einer lokalen Veränderung der räumlichen Temperaturverteilung nicht nur in der Zwischenschicht, sondern auch in der Deckschicht. Wird nämlich beispielsweise der wenigstens eine oberflächennahe Bereich der Zwischenschicht über die darüber liegende Deckschicht erwärmt, so weist die Deckschicht in Bereichen über Defekten eine höhere Temperatur auf, da die Wärme über die darunter liegenden defekten Bereiche der Zwischenschicht langsamer abgeführt wird. Bei einem Abkühlen der Deckschicht hingegen sind die über Defekten liegenden Bereiche der Deckschicht kühler, da Wärme dort langsamer aus der Zwischenschicht nachströmt.

Auf diese Weise lassen sich somit Defekte an der Oberfläche der Zwischenschicht zerstörungsfrei erkennen, so daß sämtliche Leiterplattenrohlinge unmittelbar nach deren Herstellung oder vor der Bestückung mit elektronischen Bauteilen zuverlässig überprüft werden können.

Vorzugsweise wird der Temperaturgradient zumindest annähernd senkrecht zu der Zwischenschicht auszurichten sein. Prinzipiell ist es aber auch möglich, einen parallel zur der Zwischenschicht ausgerichteten Temperaturgradienten zu erzeugen, z.B. indem bei kleinen Leiterplattenrohlingen Wärme nicht von der Grund- oder Deckschicht, sondern von der Seite her zugeführt wird.

Ein Abkühlen der Deckschicht kann z.B. mit Hilfe eines kurzen Benetzens des Leiterplattenrohlings mit flüssigen Stickstoff erfolgen. Die Deckschicht wird dabei kurzzeitig um einige °C abgekühlt, so daß die angesprochenen Effekte auftreten und nachgewiesen werden können. Eine Erwärmung der Deckschicht kann z.B. mit Hilfe eines hohen Stromes erreicht werden, der aufgrund der erzeugten Ohmschen Wärme die Leiterbahnen erhitzt. Aufgrund der geringfügig unterschiedlichen elektrischen Widerstände der einzelnen Schichten, aus denen die Leiterbahnen aufgebaut sind, entsteht dann ebenfalls ein Temperaturgradient innerhalb der Zwischenschicht.

Bei einer bevorzugten Ausgestaltung der Erfindung wird jedoch zum Erzeugen eines Temperaturgradienten in dem wenigstens einem oberflächennahen Bereich der Zwischenschicht die Deckschicht durch Bestrahlung mit Licht, vorzugsweise Infrarotlicht, erwärmt.

Eine Erwärmung mit Licht hat den Vorteil, daß durch kurzzeitige energiereiche Bestrahlung ein plötzlicher Temperaturanstieg in der Deckschicht hervorgerufen werden kann, der zu einem entsprechend ausgeprägten Temperaturgradienten in der Zwischenschicht führt. Die durch die Defekte hervorgerufenen Veränderungen der Temperaturverteilung auf der Deckschicht sind dann größer, als dies bei einem langsamen Erwärmen oder Abkühlen der Fall ist.

Es ist deswegen weiter bevorzugt, wenn als Lichtquelle für die Bestrahlung der Deckschicht eine Blitzlichtlampe verwendet wird.

Auf diese Weise kann mit einfachen Mitteln eine kurzzeitige und räumlich weitgehend homogene Erwärmung des Leiterplattenrohlings erzielt werden.

Bei einer vorteilhaften Weiterbildung dieser Ausgestaltung werden als Lichtquelle mehrere Blitzlichtlampen, insbesondere Halogenröhren, verwendet.

Auf diese Weise können auch bei größeren Leiterplattenrohlingen über deren gesamte Bestückungsfläche hinweg annähernd gleichartige Ausgangsbedingungen geschaffen werden, bevor die Temperaturverteilung auf der Deckschicht erfaßt und ausgewertet wird.

Die Temperaturverteilung in der Deckschicht kann bei kleinen Leiterplattenrohlingen z.B. mit Hilfe einer Vielzahl von Temperaturfühlern erfaßt werden, die unmittelbar über den Leiterbahnen deren Oberflächentemperatur aufnehmen.

Vorzugsweise wird jedoch die Temperaturverteilung in der Deckschicht von einer Infrarotkamera erfaßt.

Auf diese Weise läßt sich besonders einfach und mit hoher räumlicher Auflösung die Temperaturverteilung der Deckschicht ermitteln. Das von der Infrarotkamera aufgenommene Temperaturbild der Deckschicht kann z.B. mehrfarbig auf einem Monitor dargestellt werden, so daß eine Bedienperson durch Analyse der Temperaturverteilung Schlüsse auf mögliche Defekte ziehen kann. Diese Analyse kann aber auch von einer geeigneten Auswerteeinrichtung, z.B. einem entsprechend programmierten Personalcomputer, übernommen werden, indem durch an sich bekannte Bildanalyseverfahren Rückschlüsse auf das Vorhandensein von Defekten gezogen werden.

Bei einer anderen vorteilhaften Ausgestaltung der Erfindung wird die Temperaturverteilung in der Deckschicht zu mindestens zwei unterschiedlichen Zeiten, insbesondere nach Erzeugen des Temperaturgradienten, erfaßt.

Auf diese Weise gewinnt man zusätzliche Informationen zum zeitlichen Abkühlverhalten (oder Aufwärmverhalten, falls die Deckschicht vorher abgekühlt wurde) der Deckschicht. Diese zusätzlichen Informationen können dazu verwendet werden, Defekte örtlich noch genauer und vor allem zuverlässiger zu detektieren. Auf Nebeneffekte, z.B. Verschmutzungen oder Kratzer, zurückzuführende Änderungen der Temperaturverteilung der Deckschicht können auf diese Weise leichter von solchen Änderungen unterschieden werden, die auf besagte Defekte zurückzuführen sind.

Bei einer besonders bevorzugten Weiterbildung dieser Ausgestaltung wird die Temperaturverteilung in der Deckschicht nach Erzeugen des Temperaturgradienten periodisch erfaßt und durch Fourier-Analyse ausgewertet.

Werden die periodisch erfaßten Temperaturverteilungen einer diskreten Fourier-Analyse unterzogen, für die sehr schnelle Berechnungsalgorithmen zur Verfügung stehen, so lassen sich auf diese Weise zusätzliche Informationen zum zeitlichen Verhalten der Deckschicht nach einer Temperaturanregung gewinnen. Auf Defekte zurückzuführende Veränderungen der Temperaturverteilung treten im Fourier-Spektrum in einem bestimmten Frequenzbereich besonders deutlich hervor.

Alternativ oder auch zusätzlich hierzu kann der Temperaturgradient in dem wenigstens einen oberflächennahen Bereich der Zwischenschicht periodisch erzeugt und die Temperaturverteilung in der Deckschicht jeweils mit gleichem zeitlichen Versatz zur Erzeugung erfaßt werden.

Auch auf diese Weise treten von Defekten verursachte Änderungen der Temperaturverteilung besonders deutlich hervor. Frequenzen, die für die periodische Temperaturanregung der Zwischenschicht geeignet sind, liegen z.B. in der Größenordnung von 30 Hz und können mit Hilfe gepulster Infrarotlaser erreicht werden.

Ferner kann es vorteilhaft sein, die Temperaturverteilung in der Deckschicht auch vor Erzeugen des Temperaturgradienten nach Schritt a) zu erfassen.

Auf diese Weise kann die nach dem Erwärmen oder Abkühlen der Deckschicht erfaßte Temperaturverteilung mit einer zuvor erfaßten Temperaturverteilung verglichen werden. Dadurch läßt sich ein Differenzbild ableiten, in dem nur die Temperaturänderungen hervortreten. In diesem Differenzbild können auf Defekte zurückgehende Änderungen noch leichter erfaßt werden, da Nebeneffekte gleichsam herausgemittelt werden.

Bei der Ermittlung von Differenzverteilungen kann auch wenigstens eine Temperaturverteilung, die bei einem anderen Leiterplattenrohling erfaßt wurde, berücksichtigt werden.

So kann beispielsweise eine ganze Serie gleichartiger Leiterplattenrohlinge auf einfache Weise auf Defekte überprüft werden, indem zunächst bei Raumtemperatur bei einem Leiterplattenrohling die Temperaturverteilung der Deckschicht erfaßt wird. Anschließend werden dann bei allen weiteren Leiterplattenrohlingen nur noch Temperaturverteilungen nach einem Erwärmen oder Abkühlen der Deckschicht erfaßt. Für jeden Leiterplattenrohling wird dann eine Differenzverteilung unter Verwendung der einmal bei Raumtemperatur aufgenommenen Temperaturverteilung und der jeweils nach Erwärmung oder Abkühlen erfaßten Temperaturverteilung ermittelt.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Weitere Vorteile und Merkmale der Erfindung ergeben sich aus der Beschreibung des nachfolgenden Ausführungsbeispiels anhand der Zeichnung. Darin zeigen:
Fig. 1 einen Ausschnitt aus einem Leiterplattenrohling in einem seitlichen Schnitt, der einen Defekt in einem oberflächennahen Bereich der Zwischenschicht aufweist;
Fig. 2 eine erfindungsgemäße Vorrichtung zur Detektion eines derartigen Defekts in einer schematischen Darstellung;
Fig. 3 einen Graphen, in dem für zwei unterschiedliche Orte auf der Deckschicht die Temperatur über der Zeit aufgetragen ist.

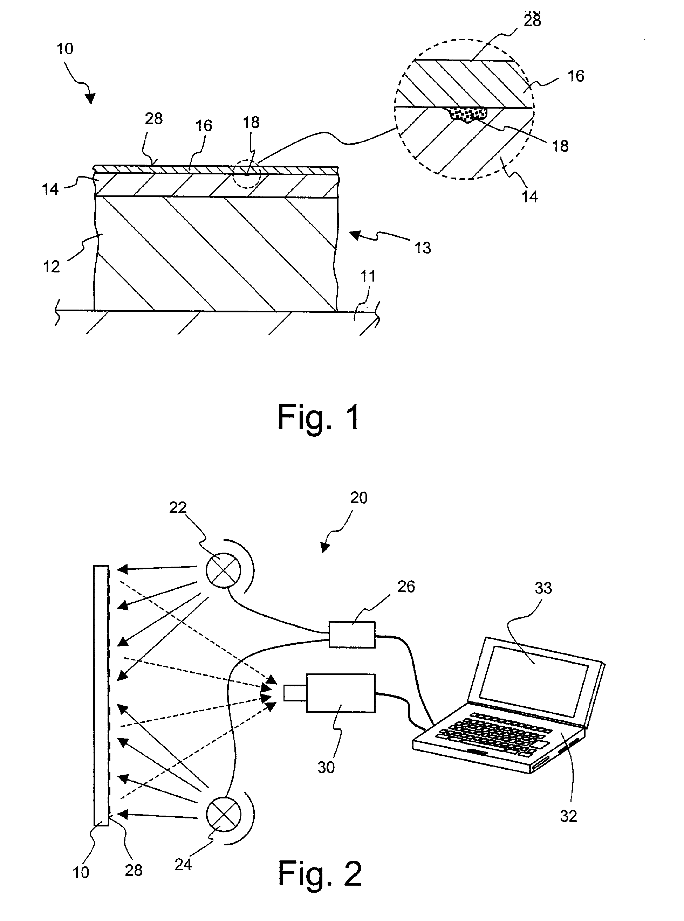

In Fig. 1 zeigt einen Ausschnitt aus einem ENIG-Leiterplattenrohling 10 in einem seitlichen Schnitt in nicht maßstäblicher Darstellung. Angedeutet ist ein Träger 11, der z.B. aus einem Polyimid bestehen kann. Darauf ist eine Leiterbahn 13 aufgebracht, die im wesentlichen aus einer Grundschicht 12 aus Kupfer besteht. Darauf ist eine dünne Zwischenschicht 14 aus Nickel abgeschieden, die wiederum von einer noch dünneren Deckschicht 16 aus Gold bedeckt ist. Bei typischen Leiterplattenrohlingen dieser Art beträgt die Dicke der Zwischenschicht 14 z.B. 5 µm und die Dicke der Deckschicht 16 etwa 70 nm. Der Leiterplattenrohling 10 wird zur Herstellung von Leiterplatten von der Bestückungsseite 28 her bestückt, indem elektronische Bauteile durch die Deckschicht 16 hindurch mit der Zwischenschicht 12 verlötet werden. Das Gold der Deckschicht 16 diffundiert dabei in das verwendete Lot, welches die Zwischenschicht 14 aus Nickel benetzt.

Die Zwischenschicht 14 weist einen Defekt 18 auf, der, wie in der vergrößerten Darstellung erkennbar ist, z.B. aus einer durch Korrosion entstandenen, mit Nickelphosphid angefüllten kleinen Ausnehmung bestehen kann. Falls nun versucht wird, im Bereich des Defektes 18 ein elektrisches Bauelement auf der Leiterbahn anzulöten, so kann der Defekt 18 dazu führen, daß das Bauelement nicht zuverlässig mit der Zwischenschicht 12 verlötet wird und unter Umständen sogar von der Leiterplatter herabfallen kann.

Fig. 2 zeigt ein Ausführungsbeispiel einer erfindungsgemäßen Detektorvorrichtung 20 in einer schematischen Darstellung, mit der einer derartiger Defekt 18 zuverlässig und zerstörungsfrei erkannt werden kann. Dargestellt sind zwei als Halogenröhren ausgebildete Blitzlichtlampen 22 und 24, die von einem Steuergerät 26 angesteuert werden. Die Blitzlichtlampen 22 und 24 sind derart beabstandet von dem Leiterplattenrohling 10 angeordnet, daß die Bestückungsseite 28 des Leiterplattenrohlings 10 parallel und annähernd gleichmäßig von den Blitzlichtlampen 22 und 24 beleuchtet wird.

Die erfindungsgemäße Detektorvorrichtung 20 weist ferner eine Infrarotkamera 30 auf, deren Optik einen Teilbereich oder die gesamte Bestückungsseite 28 des Leiterplattenrohlings 10 aufnehmen kann. Die Infrarotkamera 30 sowie die Steuereinrichtung 26 sind in dem dargestellten Ausführungsbeispiel mit einer Steuer- und Auswerteinrichtung 32 verbunden, bei der es sich z.B. um einen entsprechend programmierten Personalcomputer handeln kann. Die Steuer- und Auswerteinrichtung 32 umfaßt einen Monitor 33, auf dem die von der Infrarotkamera 30 aufgenommenen Temperaturbilder vorzugsweise mehrfarbig dargestellt werden können. Ferner hat die Steuer- und Auswerteinrichtung 32 die Aufgabe, über das Steuergerät 26 die Blitzlichtlampen 22 und 24 mit einer geeigneten Blitzdauer einzuschalten und dies mit den von der Infrarotkamera 30 gemachten Aufnahmen zeitlich zu synchronisieren. Bei Versuchen hat sich gezeigt, daß Blitzdauern zwischen einer 3/100 und einer 6/100 Sekunde zu besonders guten Ergebnissen führen.

Das von den Blitzlichtlampen 22 und 24 ausgesandte Licht trifft auf die von der Deckschicht 16 gebildete Bestückungsseite 28 des Leiterplattenrohlings 10 und führt dort zu einer Erwärmung. Diese Wärme wird durch Wärmeleitung in die darunter liegende Zwischenschicht 14 und schließlich in die Grundschicht 12 des Leiterplattenrohlings 10 abgeleitet. Dort, wo in der Zwischenschicht Defekte 18 vorhanden sind, wird die Wärmeleitung behindert. Der darüber liegende kleine Bereich der Deckschicht 16 weist daher eine geringfügig höhere Temperatur als die umgebenden Bereiche auf. Diese Temperaturabweichung wird von der Infrarotkamera 30 erfaßt und auf dem Monitor dargestellt. Eine Bedienperson kann diese Temperaturabweichung erkennen und den betreffenden Leiterplattenrohling aussondern. Dies kann ggf. auch automatisch durchgeführt werden, wenn die Steuer- und Auswerteeinrichtung 32 über entsprechende Bildanalyse-Fähigkeiten verfügt. Das Aussondern kann dann z.B. von einem Auswerfer oder einem Roboterarm vollzogen werden.

Um die relativ kleinen Temperaturdifferenzen auf der Bestükkungsseite 28 des Leiterplattenrohlings 10 zuverlässiger erfassen und von Rauscheffekten unterscheiden zu können, werden vorzugsweise mehrere Temperaturbilder der Bestückungsseite 28 von der Infrarotkamera 30 aufgenommen, die jeweils einer bestimmten Temperaturverteilung entsprechen. Die dadurch gewonnene Zusatzinformation kann insbesondere dazu verwendet werden, Abweichungen der Temperaturverteilung, die nicht durch Defekte 18 hervorgerufen, sondern beispielsweise durch an sich unschädliche Defekte in der Deckschicht 16 selbst hervorgerufen wurden, von Defekten 18 in der Zwischenschicht 14 zu unterscheiden.

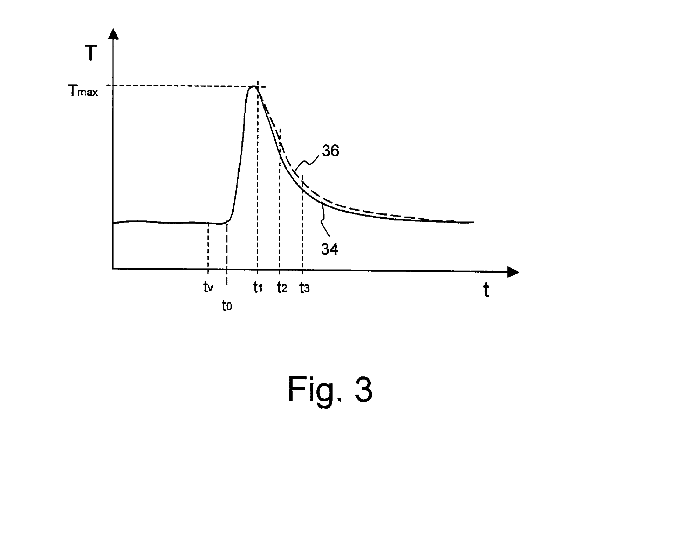

Fig. 3 zeigt einen Graphen, in dem für einen bestimmten Punkt auf der Bestückungsseite 28 des Leiterplattenrohlings 10 die Temperatur T über der Zeit t aufgetragen ist. Mit t₀ ist der Zeitpunkt bezeichnet, zu dem die Blitzlichtlampen 22 und 24 betätigt werden. Die als Infrarotlicht zugeführte Energie führt zu einer sprunghaften Erwärmung der Bestückungsseite 28 an diesem Punkt, bis eine Maximaltemperatur Tₘₐₓ erreicht wird. Danach kühlt sich die Bestückungsseite 28 an diesem Punkt nach und nach wieder ab, wie dies in Fig. 3 durch eine erste Abklingkurve 34 gezeigt ist.

Falls sich an der betreffenden Stelle auf der Bestückungsseite 28 jedoch ein Defekt 18 befindet, so wird die Wärmeabfuhr in darunter liegende Schichten des Leiterplattenrohlings 10 behindert. Dadurch ist die Temperatur an derartigen Stellen der Bestückungsseite 28 geringfügig höher als in deren Umgebung. In Fig. 3 ist dieser Fall durch eine zweite, gestrichelt dargestellte Abklingkurve 36 wiedergegeben.

Wenn nun zu mehreren Zeitpunkten t₁, t₂ und t₃ die Temperaturverteilung der Deckschicht 16 erfaßt wird, so lassen sich dadurch zuverlässiger Defekte 18 detektieren. Falls nämlich nur zu einem Zeitpunkt eine Temperaturverteilung erfaßt wird, so ließe sich die relativ geringe Temperaturdifferenz, die zwischen einem über einem Defekt 18 und außerhalb eines solchen Defektes 18 liegenden Ort auf der Bestückungsseite 28 besteht, nur schwer von einem allgemeinen Signalrauschen unterscheiden. Wenn jedoch, wie dies in Fig. 3 dargestellt ist, zu mehreren Zeiten die Temperaturverteilung erfaßt wird, so können durch statistische Auswertung signifikante Temperaturabweichungen zuverlässig erkannt werden.

Obwohl Defekte 18 durchaus mit bloßem Auge auf dem Monitor 33 der Steuer- und Auswerteeinrichtung 32 erkennbar sind, wird eine vollautomatische Auswertung von mehreren aufgenommenen Temperaturverteilungen im Rahmen der vorliegenden Erfindung bevorzugt. Bei einer solchen vollautomatischen Auswertung können zur weiteren Rauschminimierung auch Differenzverteilungen erzeugt werden, bei denen von Temperaturverteilungen, die z.B. zu einer der Zeiten t₁, t₂ oder t₃ aufgenommen wurden, eine noch vor der Belichtung zur Zeit tᵥ aufgenommene Temperaturverteilung subtrahiert werden. Dadurch lassen sich Untergrundeffekte zumindest teilweise herausmitteln.

Bei identischen Leiterplattenrohlingen ist es auch möglich, die Temperaturverteilung zur Zeit tᵥ nur einmal für alle Leiterplattenrohlinge mit Hilfe der Infrarotkamera 30 aufzunehmen. Diese Temperaturverteilung wird dann für alle anderen Leiterplattenrohlinge, die ebenfalls überprüft werden sollen, von den nach der Erwärmung erfaßten Temperaturverteilungen abgezogen. Auf diese Weise läßt sich eine sehr große Zahl von Leiterplattenrohlingen zuverlässig und zerstörungsfrei auf Defekte überprüfen, da die einzelnen Leiterplatten lediglich kurz belichtet und die Abklingkurven mit Hilfe mehrerer Aufnahmen durch die Infrarotkamera 30 aufgenommen zu werden brauchen.

Die Steuer- und Auswerteinrichtung 32 kann ferner geeignete Programmittel aufweisen, mit deren Hilfe sich die aufgenommenen Temperaturverteilungen einer diskreten Fourier-Analyse unterziehen lassen. Im Fourier-Spektrum treten die durch Defekte 18 verursachten Änderungen in den Temperaturverteilungen noch deutlicher hervor. Dabei können entweder in periodischen Abständen mehrere Temperaturverteilungen aufgenommen werden oder aber in periodischen Abständen Belichtungen vorgenommen werden, zu denen jeweils eine Temperaturverteilung aufgenommen wird. Als Lichtquelle kommt dann anstelle der Blitzlichtlampen 22 und 24 z.B. ein im Pulsbetrieb betreibbarer Infrarotlaser in Betracht, dessen Strahl über eine geeignete Streuoptik auf den Leiterplattenrohling 10 trifft.

## Patentansprüche

1. Verfahren zur Detektion von oberflächennahen Defekten (18) in Leiterplattenrohlingen (10), die in einer Zwischenschicht (14) unterhalb einer den Leiterplattenrohling (10) zu einer Bestückungsseite (28) hin abschließenden Deckschicht (16) auftreten, **gekennzeichnet durch** folgende Schritte:
a) Erzeugen eines vorzugsweise senkrecht zur Zwischenschicht (14) ausgerichteten Temperaturgradienten in wenigstens einem oberflächennahen Bereich der Zwischenschicht (14);
b) Erfassen der Temperaturverteilung in der Deckschicht (16).

2. Verfahren nach Anspruch 1, **dadurch gekennzeichnet, daß** zum Erzeugen eines Temperaturgradienten in dem wenigstens einen oberflächennahen Bereich der Zwischenschicht (14) die Deckschicht (16) durch Bestrahlung mit Licht, vorzugsweise Infrarotlicht, erwärmt wird.

3. Verfahren nach Anspruch 2, **dadurch gekennzeichnet, daß** als Lichtquelle für die Bestrahlung der Deckschicht eine Blitzlichtlampe (22, 24) verwendet wird.

4. Verfahren nach Anspruch 3, **dadurch gekennzeichnet, daß** als Lichtquelle mehrere Blitzlichtlampen, insbesondere Halogenröhren (22, 24), verwendet werden.

5. Verfahren nach einem der vorhergehenden Ansprüche, **dadurch gekennzeichnet, daß** die Temperaturverteilung in der Deckschicht (16) von einer Infrarotkamera (30) erfaßt wird.

6. Verfahren nach einem der vorhergehenden Ansprüche, **dadurch gekennzeichnet, daß** die Temperaturverteilung in der Deckschicht (16) zu mindestens zwei unterschiedlichen Zeiten (t₁, t₂, t₃, tᵥ) erfaßt wird.

7. Verfahren nach Anspruch 6, **dadurch gekennzeichnet, daß** die Temperaturverteilung in der Deckschicht (16) auch vor Erzeugen des Temperaturgradienten nach Schritt a) erfaßt wird.

8. Verfahren nach Anspruch 6 oder 7, **dadurch gekennzeichnet, daß** die Temperaturverteilung in der Deckschicht (16) zu mindestens zwei unterschiedlichen Zeiten (t₁, t₂, t₃) nach Erzeugen des Temperaturgradienten erfaßt wird.

9. Verfahren nach Anspruch 8, **dadurch gekennzeichnet, daß** die Temperaturverteilung in der Deckschicht (16) nach Erzeugen des Temperaturgradienten periodisch erfaßt und durch Fourier-Analyse ausgewertet wird.

10. Verfahren nach einem der Ansprüche 7 bis 9, **dadurch gekennzeichnet, daß** aus Temperaturverteilungen, die zu unterschiedlichen Zeiten erfaßt worden sind, Differenzverteilungen gebildet werden.

11. Verfahren nach Anspruch 10, **dadurch gekennzeichnet, daß** zur Ermittlung von Differenzverteilungen auch wenigstens eine Temperaturverteilung, die bei einem anderen Leiterplattenrohling (10) erfaßt wurde, berücksichtigt wird.

12. Verfahren nach einem der vorhergehenden Ansprüche, **dadurch gekennzeichnet, daß** der Temperaturgradient in dem wenigstens einen oberflächennahen Bereich der Zwischenschicht (14) periodisch erzeugt und die Temperaturverteilung in der Deckschicht (16) jeweils mit gleichem zeitlichen Versatz zur Erzeugung erfaßt wird.

13. Verfahren nach einem der vorhergehenden Ansprüche, **dadurch gekennzeichnet, daß** die Zwischenschicht (14) aus Nickel und die Deckschicht (16) aus Gold besteht.

14. Vorrichtung zur Detektion von oberflächennahen Defekten (18) in Leiterplattenrohlingen (10), die in einer Zwischenschicht (14) unterhalb einer den Leiterplattenrohling (10) zu einer Bestückungsseite (28) hin abschließenden Deckschicht (16) auftreten, **gekennzeichnet durch**:
a) ein Heiz- oder Kühlmittel (22, 24) zum Erzeugen eines vorzugsweise senkrecht zur Zwischenschicht (14) ausgerichteten Temperaturgradienten in wenigstens einem oberflächennahen Bereich der Zwischenschicht;
b) einen Temperaturmesser (30) zum Erfassen der Temperaturverteilung in der Deckschicht (16).

15. Vorrichtung nach Anspruch 14, **dadurch gekennzeichnet, daß** das Heizmittel eine Lichtquelle, vorzugsweise eine Infrarotlichtquelle (22, 24) ist.

16. Vorrichtung nach Anspruch 15, **dadurch gekennzeichnet, daß** die Lichtquelle eine Blitzlichtlampe (22, 24) ist.

17. Vorrichtung nach Anspruch 16, **dadurch gekennzeichnet, daß** die Lichtquelle mehrere Blitzlichtlampen (22, 24), insbesondere Halogenröhren, aufweist.

18. Vorrichtung nach einem der Ansprüche 14 bis 17, **dadurch gekennzeichnet, daß** der Temperaturmesser eine Infrarotkamera (30) ist.

19. Vorrichtung nach Anspruch 18, **dadurch gekennzeichnet, daß** die Infrarotkamera (30) mehrere Bilder pro Sekunde aufnehmen kann.

20. Vorrichtung nach einem der Ansprüche 14 bis 19, **gekennzeichnet durch** eine Auswerteeinrichtung (32) zur Auswertung der von dem Temperaturmesser (30) ermittelten Temperaturverteilungen.

21. Vorrichtung nach Anspruch 20, **dadurch gekennzeichnet, daß** die Auswerteeinrichtung (32) einen Vergleicher aufweist, in dem unterschiedliche Temperaturverteilungen durch Differenzbildung miteinander vergleichbar sind.
